(19) **Europäisches Patentamt**

**European Patent Office**

**Office européen des brevets**

(11) **EP 0 583 374 B1**

(12) **EUROPEAN PATENT SPECIFICATION**

(45) Date of publication and mention
of the grant of the patent:
**26.07.2000 Bulletin 2000/30**

(51) Int. Cl.⁷: **B05D 3/06**, C23C 16/44,
C23C 16/26, C23C 16/50

(21) Application number: **92911953.5**

(22) Date of filing: **08.05.1992**

(86) International application number:
**PCT/US92/04035**

(87) International publication number:
**WO 92/20464 (26.11.1992 Gazette 1992/29)**

(54) **METHOD AND APPARATUS FOR PLASMA DEPOSITION**

VERFAHREN UND VORRICHTUNG ZUR PLASMABESCHICHTUNG

PROCEDE ET APPAREIL DE DEPOSITION PAR JET DE PLASMA

(84) Designated Contracting States:
**DE FR GB**

(30) Priority: **10.05.1991 US 698538**
**10.05.1991 US 698446**

(43) Date of publication of application:
**23.02.1994 Bulletin 1994/08**

(60) Divisional application:
**99119093.5 / 0 969 120**

(73) Proprietor: **CELESTECH, INC.**
**Irvine, CA 92178 (US)**

(72) Inventors:
• **CANN, Gordon, L.**
**Laguna Beach, CA 92651 (US)**
• **SHEPARD, Cecil, B., Jr.**
**Laguna Beach, CA 92651 (US)**
• **McKEVITT, Frank, L.**
**Anaheim Hills, CA 92807 (US)**

(74) Representative:
**Skone James, Robert Edmund**
**GILL JENNINGS & EVERY**
**Broadgate House**
**7 Eldon Street**
**London EC2M 7LH (GB)**

(56) References cited:
| | |
|---|---|
| EP-A- 0 012 440 | EP-A- 0 165 565 |
| JP-A- 1 242 141 | JP-A- 1 312 008 |
| JP-A- 59 021 026 | JP-A- 59 043 861 |
| JP-A- 63 289 926 | US-A- 4 292 342 |
| US-A- 4 487 162 | US-A- 4 505 947 |
| US-A- 4 767 608 | US-A- 5 068 871 |
| US-A- 5 094 878 | |

• DATABASE WPI Section Ch, Week 8930, Derwent Publications Ltd., London, GB; Class E36, AN 89-218149 & JP-A-1 157 498 (KAGAKU GIJUTSU-CHO KINZ) 20 June 1989
• PLASMA CHEMISTRY AND PLASMA PROCESSING, MARCH 1989, USA, VOL. 9, NR. 1, SUPPL., PAGE(S) 195S - 206, ISSN 0272-4324 Goldfarb V et al 'Deposition of thin films and coatings by atmospheric pressure vapor plasma jet'

**Description**

FIELD OF THE INVENTION

This invention relates to plasma deposition of substances and, more particularly, to plasma deposition on a substrate of films of material such as synthetic diamond by techniques utilizing a plasma jet.

BACKGROUND OF THE INVENTION

Techniques for depositing substances, such as layers of semiconductor material, using a plasma that is formed into a jet, are well known. For example, my U.S. Patent No.s 4,471,003 and 4,487,162 disclose arc jet plasma deposition equipment which utilizes a plasma for deposition of semiconductors and other materials. Ions and electrons are obtained by injecting an appropriate compound, such as a silicon compound, into an arc region, and a jet (or beam) is formed by utilizing magnetic fields to accelerate and focus the plasma. Recently, equipment of this type has been used to deposit synthetic diamond. Superior physical and chemical properties make diamond desirable for many mechanical, thermal, optical and electronic applications, and the ability to deposit synthetic diamond by plasma jet deposition holds great promise, particularly if plasma jet techniques can be improved for this and other purposes.

In plasma jet deposition techniques there are various factors which limit the practical size of the deposition area that is active on a substrate at a particular moment. For example, when an arc is employed to generate the heated gas mixture in an arc jet plasma deposition system, the diameter of the effluent beam can be limited by a number of factors. For practical reasons the orifice from the arc chamber is of limited area. If the gas is expanded supersonically, the exit area of the nozzle will be determined by the pumping rate of the vacuum pumping system, so the vacuum pumping capability is a limiting factor in this regard. Expansion of the gas subsonically can result in heat transfer to the nozzle walls and significantly reduce the gas enthalpy. Also, the number density of key species in the flow can be degraded by volume reactions. Further, overly expanding the beam can diminish economic efficiency since the diamond yield may depend on the carbon impingement rate or upon the power density.

In various commercial applications it is desirable, or may become desirable, to have relatively large size diamond films. Since, for reasons just summarized, among others, the cross-section of the plasma beam is generally limited in practical applications, the area on which it is desired to deposit a diamond film may be many times larger than the deposition beam. This means that the beam and the target substrate need to be moved with respect to each other during the deposition process, which gives rise to a number of problems.

The film will have a temperature gradient associated with power density from the impinging jet, and the film will tend to experience thermal cycling as the substrate moves with respect to the beam. The temperature gradients and/or thermal cycling tend to stress the diamond film, and can cause it to crack or spall off the substrate. Even if the film remains intact on the substrate, it may contain internal stress defects that can render it unacceptable for the purpose for which it was intended.

It is among the objects of the present invention to provide an apparatus and method which is responsive to the prior art limitations and problems described above and which facilitates production of relatively large area films, such as diamond films, of improved properties and with improved production efficiency.

When a heated plasma jet impinges on a substrate, a significant fraction of the plasma beam is channeled around the substrate without coming in contact with the substrate surface. The energy invested in processing the bypassing portion of the flow into the necessary species of the plasma (e.g. carbon molecules, radicals, and atomic hydrogen, for the case of diamond deposition) does not result in effective deposition, and this substantially increases the cost of the process. Inefficient deposition also increases the time necessary to obtain a desired layer thickness and can waste constituent feedstock. Recycling of feedstock (particularly hydrogen) is possible, but also involves some cost.

It is among the further objects of the present invention to improve the efficiency of plasma jet deposition of substances.

V. Goldfarb et al., Deposition of thin films and coatings by atmospheric pressure plasma jet, Plasma chemistry and plasma processing 9 (1989) March, No. 1, suppl., 195-206 discloses a coating method in which the substrate is put in planetary rotation. JP-A-1157498 also discloses a coating process in which the substrate undergoes planetary rotation. This is undesirable since the substrate is taken repeatedly in and out of the path of the beam which will result, inter alia, in an undesirable temperature cycling and lack of temperature uniformity.

In accordance with one aspect of the present invention, a method for depositing synthetic diamond comprises the steps of:

    producing a plasma beam containing a carbonaceous gas and hydrogen gas;
    providing a substrate (150) having a surface in the path of the beam, the area of the surface being larger than the cross-sectional area of the beam impinging on the surface; and
    spinning the substrate (150) with respect to the beam, about an axis passing through and perpendicular to the substrate, to control temperature variation on the surface as the beam deposits the synthetic diamond on the surface, at least a portion of said surface being in the path of said beam throughout said depositing of diamond.

In accordance with a second aspect of the present invention, a method for depositing synthetic diamond comprises the steps of:

producing a plasma beam containing a carbonaceous gas and hydrogen gas;
providing a substrate (150) having a surface in the path of the beam, the substrate being tilted at an angle of at least 10 degrees with respect to the plane perpendicular to the beam direction; and introducing repetitive translatory motion between the substrate and the beam as the synthetic diamond is deposited on the surface.

In accordance with a third aspect of the present invention, apparatus for depositing synthetic diamond comprises:

means for producing a plasma beam containing a carbonaceous gas and hydrogen gas;
a substrate (150) having a surface in the path of the beam, the area of the surface being larger than the cross-sectional area of the beam impinging on the surface; and
means for spinning the substrate with respect to the beam, about an axis passing through and perpendicular to the substrate, to control temperature variation on the surface as the beam deposits the synthetic diamond on the surface, at least a portion of said surface being in the path of said beam throughout said depositing of diamond.

SUMMARY OF THE INVENTION

In accordance with a feature of the present invention, the temperature variation of a substrate and a substance being deposited thereon is controlled, both temporally and spatially, by moving the substrate and the deposition beam with respect to each other at a rate which results in no more than a certain maximum temperature variation for specified operating conditions.

The invention is directed to a method and apparatus for depositing synthetic diamond. A plasma beam is produced, and contains the constituents of the substance to be deposited. [As used herein, the term "beam" is intended to generically include the terms beam and jet.] In a form of the invention, a substrate is provided, and has a surface (that is, at least one surface) in the path of the beam, the area of said surface being substantially larger than the cross-sectional area of the beam impinging on the surface. Repetitive motion (that is, motion in a pattern that substantially repeats) is introduced between the substrate and the beam as the substance is deposited on the surface. The substrate, the beam, or both can be moved. Spinning of the substrate, with the beam non-concentric thereon, is one preferred technique. The substrate can be tilted at a substantial angle (at least 10 degrees) with respect to the plane perpendicular to the beam direction, and the step of repetitively moving the substrate with respect to the beam may comprise moving the substrate back and forth with a component of motion perpendicular to the direction of the beam.

In general, when spinning of the substrate is employed, a rotation rate of at least about 500 rpm is preferred, with substantially higher rates of several thousand rpm being recommended for most situations. As described hereinbelow, factors such as the beam energy, the beam and substrate coverage geometries, and the properties of the substrate material all enter into the computation of the velocity (of the substrate and beam with respect to each other) that is necessary to keep temperature variations under control. Selection of substrate materials having favorable properties, particularly density and thermodynamic properties, will tend to reduce the velocity needed to attain a particular temperature deviation limit. Copper, tungsten, molybdenum, tungsten carbide, and molybdenum carbide have relatively favorable properties. Other attributes which should be taken into account pertain to the compatibility with the substance being deposited, including retention of the substance on the substrate, and the relative coefficients of expansion.

Further features and advantages of the invention will become more readily apparent from the following detailed description when taken in conjunction with the accompanying drawings.

BRIEF DESCRIPTION OF THE DRAWINGS

Fig. 1 is a diagram, partially in schematic form, of an apparatus in accordance with an embodiment of the invention and which can be utilized to practice an embodiment of the method of the invention.
Fig. 2 is a diagram, partially broken away, of a portion of the Fig. 1 apparatus in accordance with another embodiment of the invention.
Fig. 3 illustrates the beam impingement area of the Fig. 2 embodiment.

DETAILED DESCRIPTION

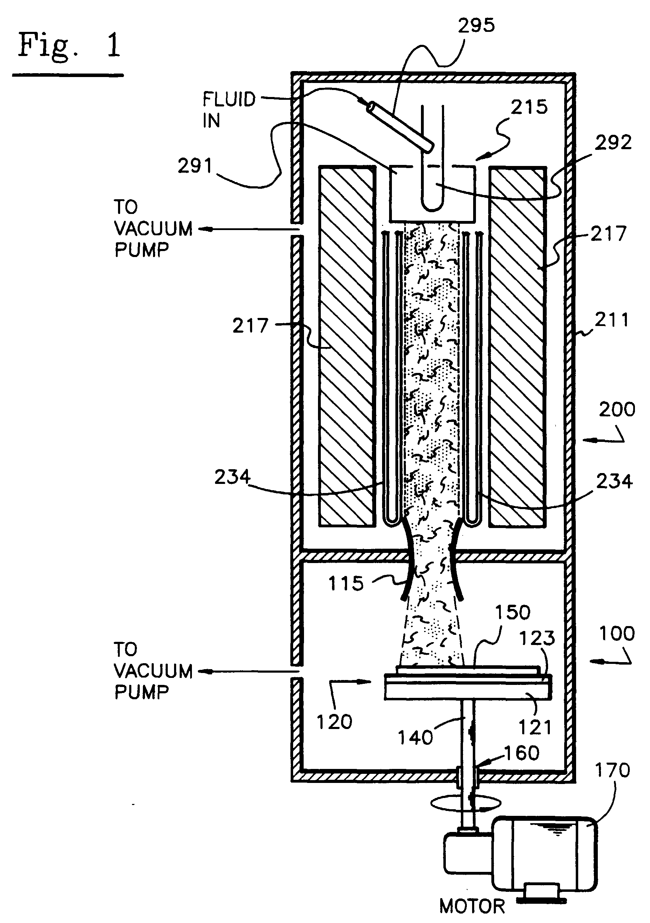

Referring to Fig. 1, there is shown an embodiment of an apparatus in accordance with the invention and which can be used to practice an embodiment of a method the invention. A deposition chamber 100 is the lower section of a plasma jet deposition system 200, evacuated by one or more vacuum pumping systems (not shown).

The system 200 is contained within a vacuum housing 211 and includes an arc-forming section 215 which comprises a cylindrical anode 291, a rod-like cathode 292, and an injector 295 mounted adjacent the cathode so as to permit injected fluid to pass over the cathode. In the illustrated embodiment the input fluid may be, for example, a mixture of hydrogen and methane. The methane could alternatively be fed in downstream. The anode 291 and cathode 292 are energized by a source of electric potential (not shown), for example a DC potential. Cylindrical magnets, designated by reference numeral 217, are utilized to accelerate and focus the plasma generated at the arc forming section. The magnets maintain the plasma within a narrow column until the plasma reaches the deposition region. A nozzle, represented at 115, can be used to control beam size, within limitations. Cooling coils 234, in which liquid nitrogen can be circulated, are located within the magnets and surround the focused plasma.

In an example of operation, a mixture of hydrogen and methane is fed to the injector 295, and a plasma is obtained in front of the arc forming section and accelerated and focused toward the deposition region. As is known in the art, synthetic polycrystalline diamond can be formed from the described plasma, as the carbon in the methane is selectively deposited as diamond, and the graphite which forms is dissipated by combination with the hydrogen facilitating gas. For further description of plasma jet deposition systems, reference can be made to U.S. Patent No.s 4,471,003 and 4,487,162. It will be understood that other suitable types of plasma beam deposition equipment can be used in conjunction with the features of the invention to be described.

The deposition chamber 100 contains a substrate holder 120 which is mounted on a shaft 140. The holder 120 includes a base 121, and a radiator 123 or other suitable device can be mounted on the base, if necessary or desired. A substrate 150 is mounted on the holder 120, such as by retainer bolts (not shown). [As used herein, the term "substrate" is intended to mean an object having at least one surface on which a substance is to be deposited. It will be understood that a substrate may only temporarily hold a deposited layer which is intended for subsequent removal from the substrate. A substrate may also be an object on which the deposited surface is intended to be permanently affixed; for example, the substrate may be the base of a wear surface of deposited synthetic diamond, such as for ultimate use in a tool.] The shaft 140, non-concentric with the beam, extends through a vacuum-tight feed-through 160 to a motor 170 which spins the shaft 140, holder 120, and substrate 150 at a desired rate during the deposition process. Alternatively, the motor could be located within the vacuum chamber.

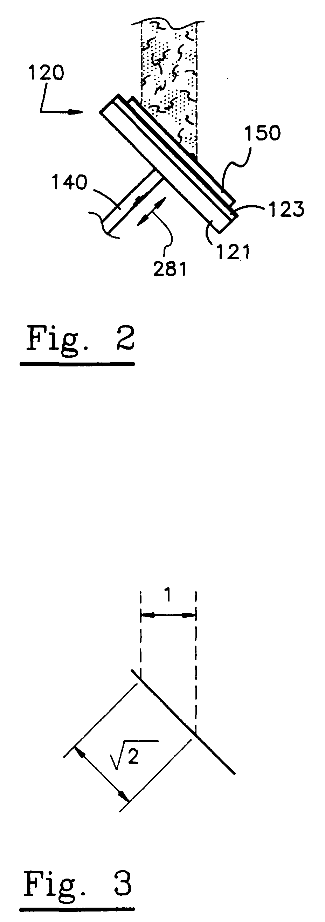

For certain applications, the substrate can be tilted at a substantial angle with respect to the plane perpendicular to the beam direction. This is illustrated in Fig. 2, wherein the substrate 150 is at a substantial angle with respect to the beam 225. [The tilt can be introduced in either the substrate or the beam.] In this example, the plane of the holder 120 (and the corresponding plane of the substrate 150) is at an angle of about 45 degrees with respect to the plane (illustrated by dashed line 295) that is perpendicular to the direction of beam 225. As seen in Fig. 3, for this case the diameter of beam impingement on the substrate is the square root of 2 times the beam diameter. A reciprocating motion (see double-headed arrow 281) can be imparted to the shaft 140 by a reciprocating motor 287 to achieve repetitive coverage on the substrate. If desired, this can be in conjunction with rotating motion imparted to the shaft. However, as such combination of motions can be relatively difficult to implement, a component of motion can be introduced in the plasma beam, such as by introducing controlled gas dynamic instabilities.

Consider the case of a generally cylindrical beam with a generally circular impingement spot on a substrate moving at a velocity V. The beam will cause the spot temperature to change with respect to the substrate by

$$\Delta T = qr/K(\pi B)^{1/2} \qquad (1)$$

where

$$B = \rho V c_p r/K$$

and

q = heat flux
r = radius of source (beam)
K = thermal conductivity of material
$\rho$ = density of material
$c_p$ = specific heat of material
V = linear velocity of heat source

For a particular heat flux and beam geometry, $\Delta T$ will tend to decrease as B increases. B, in turn, will increase with increasing velocity. B also depends on the density and the thermodynamic properties of the substrate material. Selection of substrate materials having favorable properties (i.e., which tend to increase B) will tend to reduce the velocity needed to attain a particular temperature deviation limit. Copper, tungsten, molybdenum, tungsten carbide, and molybdenum carbide have relatively favorable properties for this purpose. Other attributes which should be taken into account pertain to the compatibility with the substance being deposited, including retention of the substance on the substrate, and the relative coefficients of expansion. For a given material, the velocity necessary to have no more than a certain maximum temperature increase can be determined from relationship (1), empirically, or by other suitable means.

## Claims

1. A method for depositing synthetic diamond, comprising the steps of:

   producing a plasma beam containing a carbonaceous gas and hydrogen gas;
   providing a substrate (150) having a surface in the path of the beam, the area of the surface being larger than the cross-sectional area of the beam impinging on the surface; and
   spinning the substrate (150) with respect to the beam, about an axis passing through and perpendicular to the substrate, to control temperature variation on the surface as the beam deposits the synthetic diamond on the surface, at least a portion of said surface being in the path of said beam throughout said depositing of diamond.

2. The method as defined by claim 1, wherein the substrate is spun at a rate of at least 500 revolutions per minute.

3. The method as defined by claim 2, wherein the substrate (150) comprises a material selected from the group consisting of copper, tungsten, molybdenum, tungsten carbide, and molybdenum carbide.

4. The method as defined by any of claims 1 to 3, wherein the spinning step comprises spinning the substrate (150) on an axis (140) that is not concentric with the beam.

5. A method for depositing synthetic diamond, comprising the steps of:

   producing a plasma beam containing a carbonaceous gas and hydrogen gas;
   providing a substrate (150) having a surface in the path of the beam, the substrate being tilted at an angle of at least 10 degrees with respect to the plane perpendicular to the beam direction; and
   introducing repetitive translatory motion between the substrate and the beam as the synthetic diamond is deposited on the surface.

6. Apparatus for depositing synthetic diamond, comprising:

   means for producing a plasma beam containing a carbonaceous gas and hydrogen gas;
   a substrate (150) having a surface in the path of the beam, the area of the surface being larger than the cross-sectional area of the beam impinging on the surface; and
   means for spinning the substrate with respect to the beam, about an axis passing through and perpendicular to the substrate, to control temperature variation on the surface as the beam deposits the synthetic diamond on the surface, at least a portion of said surface being in the path of said beam throughout said depositing of diamond.

7. Apparatus as defined by claim 6, wherein the substrate (150) is tilted at an angle of at least 10 degrees with respect to the plane perpendicular to the beam direction.

8. Apparatus as defined by claim 6 or claim 7, further comprising means (287) for moving the substrate back and forth with a component of motion perpendicular to the substrate surface.

## Patentansprüche

1. Verfahren zur Ablagerung synethischen Diamants mit den Schritten:

   Erzeugung eines Plasmastrahls, der kohlenstoffhaltiges Gas und Wasserstoffgas enthält,
   Bereitstellung eines Substrats (150) mit einer im Weg des Strahls liegenden Oberfläche, deren Ausdehnung größer als die Querschnittsfläche des auf die Oberfläche auftreffenden Strahls ist, und
   Rotierenlassen des Substrats (150) gegenüber dem Strahl um eine das Substrat durchsetzende und senkrecht zu ihm verlaufende Achse zur Steuerung von Temperaturänderungen auf der Oberfläche bei der Strahlablagerung des synthetischen Diamants auf der Oberfläche, von der zumindest ein Teil während der Diamantablagerung im Weg des Strahls liegt.

2. Verfahren nach Anspruch 1, bei welchem das Substrat in Rotation mit mindestens 500 Umdrehungen pro Minute versetzt wird.

3. Verfahren nach Anspruch 2, bei welchem das Substrat (150) ein Material aufweist, das aus der Kupfer, Wolfram, Molybdän, Wolframkarbid und Molybdänkarbid enthaltenden Gruppe ausgewählt ist.

4. Verfahren nach einem der Ansprüche 1 bis 3, bei welchem der Rotationsschritt ein Rotieren des Substrats (150) um eine Achse (140) umfaßt, die nicht konzentrisch zum Strahl verläuft.

5. Verfahren zur Ablagerung synthetischen Diamants mit den Schritten:

Erzeugung eines Plasmastrahls, der ein kohlenstoffhaltiges Gas und Wasserstoffgas enthält,

Bereitstellung eines Substrats (150) mit einer im Weg des Strahls liegenden Oberfläche, wobei das Substrat um einen Winkel von mindestens 10° gegenüber der rechtwinklig zur Strahlrichtung verlaufenden Ebene geneigt ist, und

Erteilung einer sich wiederholenden translatorischen Bewegung zwischen Substrat und Strahl beim Ablagern des synthetischen Diamanten auf der Oberfläche.

6. Vorrichtung zur Ablagerung von synthetischem Diamant mit:

einer Einrichtung zur Erzeugung eines Plasmastrahls, der kohlenstoffhaltiges Gas und Wasserstoffgas enthält,

einem Substrat (150) mit einer im Weg des Strahls liegenden Oberfläche, deren Ausdehnung größer als der Querschnittsbereich des auf die Oberfläche auftreffenden Strahls ist, und

einer Einrichtung, welche das Substrat gegenüber dem Strahl um eine Achse rotieren läßt, die durch das Substrat und senkrecht zu ihm verläuft, zur Kontrolle von Temperaturänderungen auf der Oberfläche bei der Strahlablagerung des synthetischen Diamants auf der Oberfläche, von der mindestens ein Teil während der Diamantablagerung im Weg des Strahls liegt.

7. Vorrichtung nach Anspruch 6, bei welcher das Substrat (150) um einen Winkel von mindestens 10° gegenüber der senkrecht zur Strahlrichtung verlaufenden Ebene geneigt ist.

8. Vorrichtung nach Anspruch 6 oder 7, weiterhin mit einer Einrichtung (287) zur Vor- und Rückbewegung des Substrats mit einer senkrecht zur Substratoberfläche gerichteten Bewegungskomponente.

**Revendications**

1. Procédé de dépôt de diamant synthétique, comprenant les étapes consistant à :

produire un faisceau de plasma contenant un gaz carboné et de l'hydrogène gazeux ;
se procurer un substrat (150) ayant une face sur le trajet du faisceau, la surface de cette face étant supérieure à la surface de section transversale du faisceau frappant la face ; et faire tourner le substrat (150) par rapport au faisceau autour d'un axe traversant le substrat et perpendiculaire au substrat, pour régler la variation de température sur la face lorsque le faisceau dépose le diamant synthétique sur la face, au moins une partie de cette face étant sur le trajet de ce faisceau tout au long de ce dépôt de diamant.

2. Procédé selon la revendication 1, dans lequel on fait tourner le substrat à une vitesse d'au moins 500 tours par minute.

3. Procédé selon la revendication 2, dans lequel le substrat (150) comprend une matière choisie dans le groupe constitué du cuivre, du tungstène, du molybdène, du carbure de tungstène et du carbure de molybdène.

4. Procédé selon l'une quelconque des revendications 1 à 3, dans lequel l'étape de rotation comprend le fait de faire tourner le substrat (150) sur un axe (140) qui n'est pas concentrique avec le faisceau.

5. Procédé de dépôt de diamant synthétique, comprenant les étapes consistant à :

produire un faisceau de plasma contenant un gaz carboné et de l'hydrogène gazeux ;
se procurer un substrat (150) ayant une face sur le trajet du faisceau, le substrat étant incliné d'un angle d'au moins 10 degrés par rapport au plan perpendiculaire à la direction du faisceau ; et
introduire un mouvement de translation répétitif entre le substrat et le faisceau lorsque le diamant synthétique est déposé sur la face.

6. Appareil pour déposer du diamant synthétique, comprenant :

des moyens de production d'un faisceau de plasma contenant un gaz carboné et de l'hydrogène gazeux ;
un substrat (150) ayant une face sur le trajet du faisceau, la surface de la face étant supérieure à la surface de section transversale du faisceau frappant la face ; et
des moyens pour faire tourner le substrat par rapport au faisceau, autour d'un axe traversant le substrat et perpendiculaire à celui-ci, pour régler la variation de température sur la face lorsque le faisceau dépose le diamant synthétique sur la face, au moins une partie de cette face étant sur le trajet de ce faisceau tout au long de ce dépôt de diamant.

7. Appareil selon la revendication 6, dans lequel le substrat (150) est incliné d'un angle d'au moins 10 degrés par rapport au plan perpendiculaire à la direction du faisceau.

8. Appareil selon la revendication 6 ou la revendication 7, comprenant en outre des moyens (287) pour déplacer le substrat d'arrière en avant avec une composante de mouvement perpendiculaire à la face du substrat.

# Fig. 1

120

140    150

123

281    121

## Fig. 2

1

√2

## Fig. 3